# EUROPEAN PATENT APPLICATION

(11) **EP 4 116 888 A1**
(43) Date of publication of application: **11.01.2023**
(21) Application number: 21184240.6
(22) Date of filing: 07.07.2021
(51) Int. Cl.: G06N 5/04, G06N 7/00, G03F 7/20, G05B 23/02

(54) **COMPUTER IMPLEMENTED METHOD FOR DIAGNOSING A SYSTEM COMPRISING A PLURALITY OF MODULES**

(71) Applicant: ASML Netherlands B.V., 5500 AH Veldhoven (NL)
(72) Inventor: VAN HERTUM, Pieter, 5500 AH Veldhoven (NL); GKOROU, Dimitra, 5500 AH Veldhoven (NL); VAN SCHOUBROECK, Joachim, Kinley, 5500 AH, Veldhoven (NL); KAREVAN, Zahra, 5500 AH Veldhoven (NL); YPMA, Alexander, 5500 AH Veldhoven (NL)
(74) Representative: ASML Netherlands B.V.

(57) **Abstract**

A computer implemented method for diagnosing a system comprising a plurality of modules. The method comprises: receiving a causal graph, the causal graph defining (i) a plurality of nodes each representing a module of the system , wherein each module is characterized by one or more signals; and (ii) edges connected between the nodes, the edges representing propagation of performance between modules; generating a reasoning tool by augmenting the causal graph with diagnostics knowledge based on historically determined relations between performance, statistical and causal characteristics of at least one module out of the plurality of modules; obtaining a health metric of the at least one module, wherein the health metric is associated with the one or more signals associated with the at least one module; and using the health metric as an input to the reasoning tool to identify a module that is the most likely cause of the behaviour.

## Description

### FIELD

The present invention relates to diagnosing a system comprising a plurality of modules.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer). An object inspection apparatus is for example suitable for inspecting a pattern which has been applied to an object e.g. to a substrate.

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

Due to the high complexity of lithographic machines, diagnostics is a significant challenge. Especially when different modules and complex interactions between them are involved, it becomes increasingly difficult to identify the root-cause of a problem.

System Dynamics issues are a prototypical example of these complex system-wide issues that are difficult to diagnose, due to the symptoms being spread across multiple modules of the machine (ex. by disturbances travelling through the machine). Although tests exist to trace the important modules to analyze system behavior, the large amount and complexity of the data means that the time taken to find the root cause, while the machine is not operating, can be significant.

### SUMMARY

In order to enable diagnostics, a good overview of the state of the health of the system is crucial. Any aggregation and distillation of complex information is difficult and prone to information being lost. The inventors have identified that lithography system diagnostics in particular encounter a high volume of signals with many and subtle interactions, so there is no generic aggregation method that avoids this information loss.

The interpretation of an overview of the state of the health of the system is typically done by experts who have a detailed understanding of the system, its modules and the potential failure modes. However, since experts with the correct expertise are scarce, obtaining their support typically takes a lot of time. Earlier lines of diagnostic support may be able to solve many problems, however they lack the detailed system dynamics knowledge to solve the most difficult problems. Embodiments of the present disclosure are directed at solving at least a portion of these problems..

The inventors have identified that tailor-made solutions are not a scalable approach, since this requires to implicitly encode the domain knowledge into the health metric calculation and the creation of custom rules to interpret the result. The custom creation of diagnostic solutions is:
a. Error-prone: In order to create a custom solution, it is necessary to encode specific domain knowledge on a system implicitly into detection rules, statistical algorithms, machine learning, etc. This implicit encoding makes it hard to verify and forces that only certain viewpoints are incorporated limiting the custom solution to specific failure modes.
b. Hard to collaborate on: Due to implicit encoding, it is not clear what exactly is encoded and how diagnostic solutions of submodules can contribute to more abstract models. Different experts have different viewpoints and will encode their knowledge in different ways, significantly challenging interaction and collaboration.
c. Not-scalable: Many systems are similar but never exactly the same. However, creating diagnostic solutions for all of them requires a new development cycle every time. Minor changes to the system or new insights in diagnostics imply a complete update of the diagnostic solutions, and since the workings of systems (or the insights thereof) change often, this implies this way of working is not scalable.

According to one aspect of the present invention there is provided a computer implemented method for diagnosing a system comprising a plurality of modules, the method comprising: receiving a causal graph, the causal graph defining (i) a plurality of nodes each representing a module of the system, wherein each module is characterized by one or more signals; and (ii) edges connected between the plurality of nodes, the edges representing propagation of performance between modules; generating a reasoning tool by augmenting the causal graph with diagnostics knowledge based on historically determined relations between performance (out-of-specification), statistical (out-of-population) and causal (root cause) characteristics of at least one module out of the plurality of modules; obtaining a health metric of the at least one module, wherein the health metric is associated with the one or more signals associated with the at least one module; and using the health metric as an input to the reasoning tool to identify a module that is the most likely cause of the behaviour of the system.

Embodiment of the present invention use available sensor data of a specific system (e.g. a machine) and a representation of an experts knowledge (the causal graph) to create an estimation of the most probable root-cause, significantly shortening diagnostics cycle time and enabling non-domain experts to perform the diagnosis.

Each node of the causal graph may be associated with a first score quantifying a probability that the module of the system, represented by the node in the causal graph, is behaving out-of-specification and out-of-population; and a second score quantifying a probability that the module of the system, represented by the node in the causal graph, is out-of-population without behaving out-of-specification.

Each of the edges of the causal graph may be assigned a weight quantifying the probability to which abnormal behaviour propagates from one module to another.

The health metric may define a probability that the module behaves out-of-population.

Obtaining the health metric for each module may comprise comparing the sensor signals mapped to the respective module to sensor data of at least one corresponding module of a system that is not exhibiting abnormal behaviour.

The method may further comprise generating a list of modules of the system that are potentially a root cause of the behavior of the system, and a confidence value for each module in the list defining a confidence that the respective module is the root cause of the abnormal behaviour, wherein the identified module has the highest confidence value.

The reasoning tool may comprise a network comprising: first type nodes each representing that an associated module of the system is behaving out-of-specification, and first type edges indicating a probability of out-of-specification behaviour propagating between two first type nodes; and second type nodes each connected to a corresponding first type node by a second edge indicating at least one probability relating to the module, associated with the corresponding first type node, behaving out-of-population.

The at least one probability may comprise: a probability that the module associated with the corresponding first type node is behaving out-of-specification and out-of-population; and a probability that the module associated with the corresponding first type node is behaving out-of-population without behaving out-of-specification.

The method may comprise assigning each health metric to a corresponding second type node of the second type nodes.

The network may be a Bayesian network.

The method may further comprises outputting, to a user, an indication of the module of the system that is the most likely root cause of the behavior of the system.

The system may be lithographic machine or a component of a lithographic machine.

According to another aspect of the present invention there is provided a computer-readable storage medium for diagnosing a system comprising a plurality of modules, the computer-readable storage medium comprising instructions which, when executed by a processor of a computing device cause the computing device to perform the method described herein.

According to another aspect of the present invention there is provided a computing device for diagnosing a system comprising a plurality of modules, the computing device comprising a processor configured to: receive a causal graph, the causal graph defining (i) a plurality of nodes each representing a module of the system, wherein each module is characterized by one or more signals; and (ii) edges connected between the plurality of nodes, the edges representing propagation of performance between modules; generate a reasoning tool by augmenting the causal graph with diagnostics knowledge based on historically determined relations between performance, statistical and causal characteristics of at least one module out of the plurality of modules; obtain a health metric of the at least one module, wherein the health metric is associated with the one or more signals associated with the at least one module; and use the health metric as an input to the reasoning tool to identify a module that is the most likely cause of the behaviour of the system.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a detailed view of a part of the lithographic apparatus of Figure 1;
- Figure 3 schematically depicts a computing device;
- Figure 4 is a flow chart of a process for diagnosing a system comprising a plurality of modules;
- Figure 5 illustrates an example causal graph;
- Figure 6 illustrates a reasoning tool in the form of a Bayesian network;
- Figure 7 illustrates an example Bayesian network generated using the causal graph of Figure 5;
- Figure 8 illustrates sensor data for the detection of a module behaving out-of-population; and
- Figures 9a-c illustrates use of the Bayesian network to identify a module that is the most likely cause of the behaviour of a system.

### DETAILED DESCRIPTION

Embodiments of the present disclosure related to diagnosing a system comprising a plurality of modules. The system may be a physical apparatus (e.g. a machine) comprising a plurality of modules. The term "module" is used herein generally represent software, firmware, hardware, or a combination thereof. In the case of a software implementation, the module represents program code that performs specified tasks when executed on a processor (e.g. CPU or CPUs). The program code can be stored in one or more computer readable memory devices. We refer below to an example in which the system is a lithographic apparatus comprising a plurality of hardware modules. In other examples, the system may be a particular component of a lithographic apparatus that has a plurality of modules. In yet further examples, the system may be a software product comprising a plurality of software modules.

Although specific reference may be made in this text to diagnosing a lithographic apparatus that is used in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of diagnosing a lithographic apparatus, embodiments of the invention may be used to diagnose other apparatuses, such as a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to diagnosing apparatuses using optical lithography and may be used in other applications, for example imprint lithography.

Embodiments of the invention may also be used to diagnose other apparatuses that are not used in lithography.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

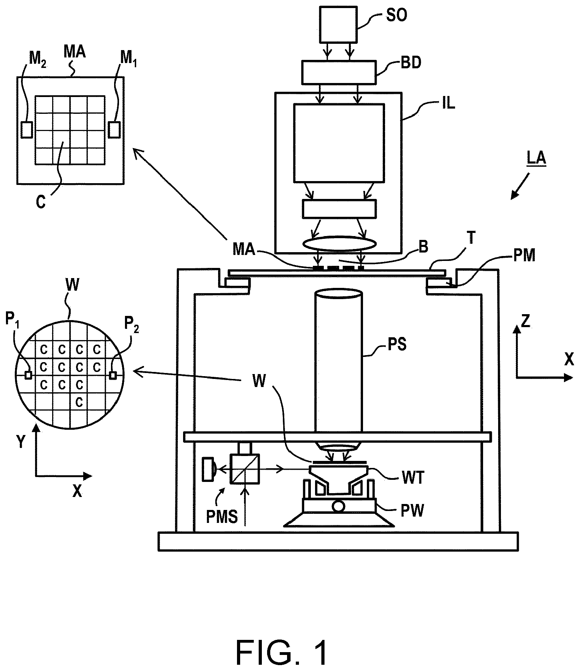

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference. The liquid may be supplied and extracted in a ring (e.g. an immersion hood IH) around the projection system PS

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

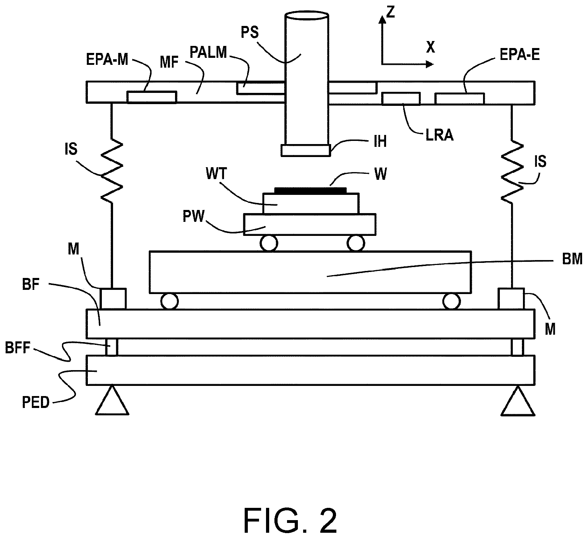

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF is mounted with passive or active air mounts AM on the base frame BF to isolate the metrology frame MF from the base frame BF. which act as an antivibration buffer to filter any external disturbances such as vibrations in the factory floor. The metrology frame MF supports the projection system PS. The metrology frame MF may supports the projection system PS by way of a piezo active lens mount PALM. Additionally, the metrology frame MF may support a part of the position measurement system PMS. The metrology frame MF is supported by the base frame BF via the vibration isolation system IS. The vibration isolation system IS mounted to the base frame via mounts M. We refer herein to the combination of the vibration isolation system IS and mounts M as airmounts AM. The vibration isolation system IS is arranged to prevent or reduce vibrations from propagating from the base frame BF to the metrology frame MF. The metrology frame MF comprises an Encoder Plate Assembly EPA comprising Encoder Plate Assembly Exposure-side EPAE and Encoder Plate Assembly Measure-side EPAM (referred collectively herein as EPA plates). The EPA plates are used as a positioning reference for the substrate support WT. A Lens Reference Axis LRA module may be arranged to determine the relative position between the EPA plates and the lens. As the substrate support WT uses the Encoder Plate Assembly EPA to position itself, the measurement distance between the Encoder Plate Assembly EPA and projection system lens can be used to determine the position of the substrate support WT with respect to the lens.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT. The driving forces of the substrate support WT and the balance mass BM generally compensate each other in the plane of movement of the substrate support or a plane parallel to the plane of movement of the substrate support WT. The centre of gravity of the substrate support WT and the centre of gravity of the balance mass BM are offset from each other in a direction perpendicular to the plane of movement of the substrate support WT. The driving forces exerted on the substrate support WT and the reaction forces exerted on the balance mass BM are typically not applied or generated in the respective centres of gravity. There is also an offset in the direction perpendicular to the plane of movement of the substrate support WT between the driving force on the substrate support WT and the driving force on the balance mass BM. These offsets together make that these driving forces generate a torque T.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

In an embodiment, the base frame BF is arranged on a support surface PED, for example a pedestal. The support surface PED is generally strong and rigid in order to provide a stable mounting surface for the lithographic apparatus. The base frame BS is supported onto the support surface by one or more frame support feet BFF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor, a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

The position measurement system PMS may comprise an encoder system. An encoder system is known from for example, United States patent application US2007/0058173A1, filed on September 7, 2006, hereby incorporated by reference. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example,+1^{st} order, -1^{st} order, +2^{nd} order and -2^{nd} order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads are arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electro-magnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.

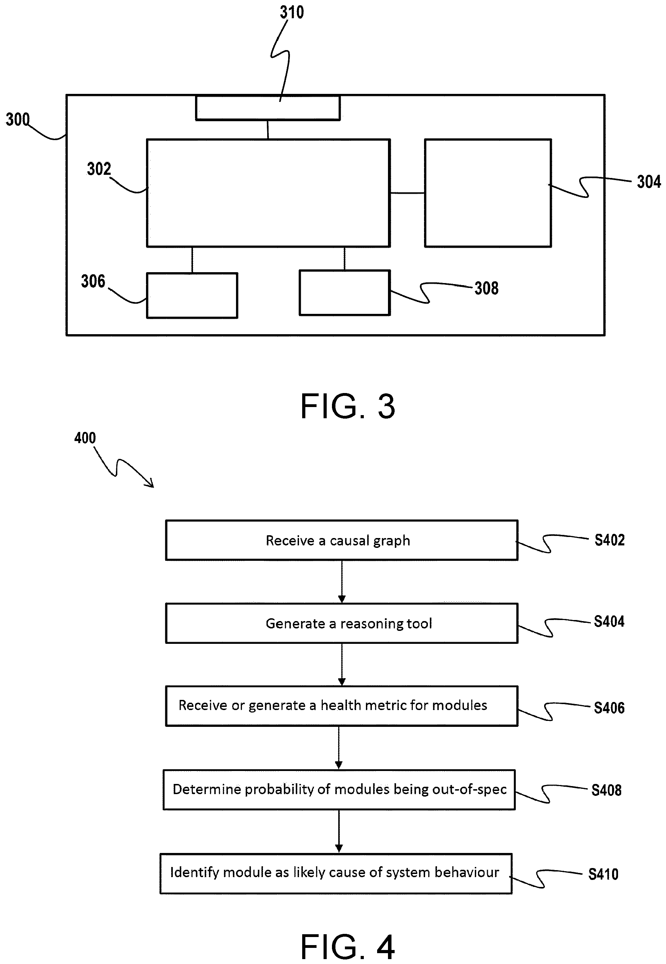

The lithographic apparatus LA comprises a position control system PCS as schematically depicted in Figure 3. The position control system PCS comprises a setpoint generator SP, a feedforward controller FF and a feedback controller FB. The position control system PCS provides a drive signal to the actuator ACT. The actuator ACT may be the actuator of the first positioner PM or the second positioner PW. The actuator ACT drives the plant P, which may comprise the substrate support WT or the mask support MT. An output of the plant P is a position quantity such as position or velocity or acceleration. The position quantity is measured with the position measurement system PMS. The position measurement system PMS generates a signal, which is a position signal representative of the position quantity of the plant P. The setpoint generator SP generates a signal, which is a reference signal representative of a desired position quantity of the plant P. For example, the reference signal represents a desired trajectory of the substrate support WT. A difference between the reference signal and the position signal forms an input for the feedback controller FB. Based on the input, the feedback controller FB provides at least part of the drive signal for the actuator ACT. The reference signal may form an input for the feedforward controller FF. Based on the input, the feedforward controller FF provides at least part of the drive signal for the actuator ACT. The feedforward FF may make use of information about dynamical characteristics of the plant P, such as mass, stiffness, resonance modes and eigenfrequencies.

Embodiments of the present invention relate to computer implemented method for diagnosing a system comprising a plurality of modules. We refer herein to an example whereby a lithographic apparatus LA such as that shown in Figure 1 is diagnosed. The computer implemented method is performed on a computing device.

Figure 3 illustrates a simplified view of a computing device 300 suitable to perform the methods described herein. A shown in Figure 3, the computing device 300 comprises a central processing unit ("CPU") 302, to which is connected a memory 304. The functionality of the CPU 302 described herein may be implemented in code (software) stored on a memory (e.g. memory 304) comprising one or more storage media, and arranged for execution on a processor comprising on or more processing units. The storage media may be integrated into and/or separate from the CPU 302. The code is configured so as when fetched from the memory and executed on the processor to perform operations in line with embodiments discussed herein. Alternatively, it is not excluded that some or all of the functionality of the CPU 302 is implemented in dedicated hardware circuitry (e.g. ASIC(s), simple circuits, gates, logic, and/or configurable hardware circuitry like an FPGA.

The computing device 102 comprises an input device 306 to allow a user to input data, the input device 306 may comprise a keyboard, mouse, touchscreen, microphone etc. The computing device 102 further comprises an output device 308 to output data to the user, the output device 308 may comprise a display and/or a speaker. The computing device 102 may comprise a communications interface 310 for communication of data to and from the computing device 102.

Figure 4 illustrates an example process 400 performed by the CPU 302 for diagnosing a system comprising a plurality of modules.

As step S402, the CPU 302 receives a causal graph associated with the system to be diagnosed. The causal graph is a custom-made abstraction that captures the potential causes of a problem with the system, their consequences and any interaction. The causal graph is a graphical representation that is easy to visualize for expert interaction, modular for composability and reusability, and formal and explicit for verification and automated reasoning. The creation of a causal graph may comprise a number of steps.

In a first step in the creation of the causal graph, a domain expert (i.e. a user with knowledge of the system that is to be diagnosed) identifies modules of the system that can be diagnosed with out-of-spec behavior. Each module in the system is represented by a node in this causal graph. This abstraction and aggregation to module level improves interaction and readability for domain experts and ensures robustness. The modules are all abstract blocks in the diagnostic problem that can either cause a problem, propagate a problem or are a discrete unit in the system.

In a second step in the creation of the causal graph, the domain expert groups sensors of the system into the identified modules. In the case of a hardware module, the sensors are physical sensors e.g. a temperature sensor, a pressure sensor, a humidity sensor, an optical sensor etc. In the case of a software module, the sensor is a virtual sensor e.g. a portion of code that reports on the functionality of the software module. The causal graph adds an abstraction level towards the many sensors in the data, by grouping them into modules. There may be many sensors in a system and while individual sensors can be exchanged or modified, this does not influence the high level interactions on the module level.

In a third step in the creation of the causal graph, the domain expert identifies influences between the modules. In particular, the domain expert adds edges to the causal graph between modules. The edges in the causal graph represent relationships between the modules: interconnectedness and problems travelling from one module to another. An edge can represent a possible propagation of disturbance between modules or can represent a dependence of performance between modules. These edges are directed, to represent the flow of time and physical causality. The domain expert assigns a weight (e.g. a score) ∈ [0,1] on each of the edges in the causal graph which quantifies the probability to which a problem propagates from one module to another.

In a fourth step in the creation of the causal graph, the domain expert also assigns each node in the causal graph with a pair of scores: a first score, P_{fn}, that quantifies the probability that this module (represented by a node in the causal graph) creates an issue and a second score (a false positive score), P_{fp}, that quantifies the probability that this module (represented by a node in the causal graph) shows to be out-of-population without actually behaving out-of-specification. A probability of a module behaving "out-of-population" characterizes the probability that the module is not exhibiting typical behavior for a healthy module of that particular type. A module behaving out-of-population might occur due to many factors (e.g. noisy sensors, too sensitive test, an issue to an neighbor module, an earthquake during the test) and not necessarily because the module is faulty. In addition, whilst a faulty module is likely to behave as an out-of-population module, the opposite can be true; a faulty module can have a low out-of-population probability because the test is not sensitive enough to capture it. As an example, a cable may not be connected to a sensor correctly.. If a sensor's normal output is zero with the cable connected, then the not connected cable might also cause the sensor to output a value of zero, causing the fault to pass unobserved. In contrast, a probability of a module behaving "out-of-specification" characterizes the probability that the module is actually faulty. The out-of-spec behavior cannot be observed directly with data or it requires costly manual inspection, in light of this it is instead indirectly estimated using a number of factors as explained in more detail below.

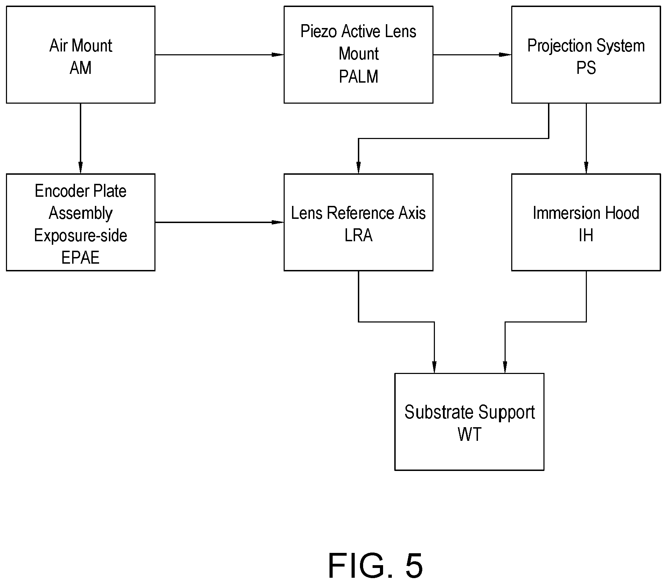

An example causal graph for the lithographic apparatus LA of Figure 1 is shown in Figure 5. As shown in Figure 5, the causal graph has a node for each of a plurality of modules: the air mounts AM, piezo active lens mount PALM, projection system PS, the Encoder Plater Assembly Exposure-side EPAE, the lens references axis LRA, the immersion hood IH, and the substrate support WT. An arrow (edge) between two nodes in the causal graph represents possible propagation of problem behavior from one to another.

Multiple domain experts may provide input to create the causal graph. In particular, experts can collaborate on the this graph and it can be constantly refined through discussion, new insights or even (automated) feedback.

The domain expert may use input device 306 of the computing device 300 to create the causal graph. Input from other domain experts may be received via communication interface 310 to create the causal graph.

As step S402, the CPU 302 may receive the causal graph from memory 304. In this scenario, an initial version of the causal graph may have been received via the communication interface 310 from a remote computing device associated with a domain expert, stored in memory 304, and then completed or finalized by the domain expert associated with the computing device 300. As an alternative, a domain expert associated with the computing device 300 may create an initial version of the causal graph and receive input via the communication interface 310 to complete or finalize it.

Alternatively, the CPU 302 may receive the causal graph via the communication interface 310. The user of the computing device 300 may have been involved in the creation of the causal graph as a domain expert, but this is not necessarily the case.

Whilst it has been described above that one or more domain experts create the causal graph, in some embodiments the CPU 302 may utilize semi-supervised machine learning techniques to learn an initial version of this causal graph (e.g. from historical data sources and/or from documentation related to the system). This initial version can then be modified and improved by human domain experts. This is possible due to the formal, but readable nature of the chosen knowledge formalism.

As step S404, to enable root-cause diagnostics the CPU 302 generates a reasoning tool using the causal graph. In particular the causal graph is translated to a formalism that contains a reasoning implementation. The causal graph is agnostic of its specific implementations for reasoning, due to its exact formal semantics. The CPU 302 generates the reasoning tool by augmenting the causal graph with diagnostics knowledge based on historically determined relations between performance (out-of-specification), statistical (out-of-population) and causal (root cause) characteristics of at least one module out of the plurality of modules of the system.

A translation algorithm executed by the CPU 302 receives the causal graph as an input and translates the causal graph into a reasoning tool that can interpret out-of-population behavior and distinguish symptoms from causes. The reasoning tool can take many different forms.

One example reasoning tool is a Bayesian network. A Bayesian network may be implemented due to its native treatment of uncertainties through conditional probabilities and prior distributions of expected behavior. The translation towards a Bayesian Network adds a reasoning capability that allows for nuanced reasoning and the incorporation of knowledge of prior distributions with the data-evidence collected for a specific machine. New knowledge introduced in the translation towards the Bayesian Network enables the reasoning system to understand false positives and the difference between a module being the root-cause of a problem and behaving out-of-specification due to issues travelling from other modules. This part of knowledge is abstracted away from the domain-expert since it is not related to the specific system but is generic for any diagnostic task.

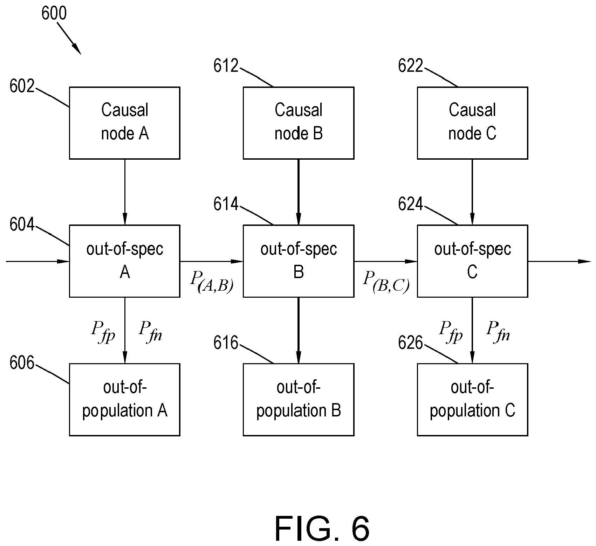

In the context of a Bayesian network, every node in the causal graph (representing a module of the system) is translated to three nodes in the Bayesian Network. A generic Bayesian network 600 is shown in Figure 6 and shows that every node in the causal graph is translated to:
1. A 'root-cause' node 602, 612, 622 representing the probability that this module is the root-cause of this problem
2. An 'out-of-specification' node 604, 614, 624 representing the probability that this module is behaving faulty, being through travelling disturbances from a nearby module or through being the cause (distinguishing from 1.)
3. An 'out-of-population' (observational) node 606, 616, 626 representing the probability that this module is misbehaving, allowing the network to account for false positives (distinguishing from 2.)

Thus it can be seen that a first causal node A in the causal graph is associated with a 'root-cause' node 602, an 'out-of-specification' node 604, and an 'out-of-population' node 606 in the Bayesian Network. A second causal node B in the causal graph is associated with a 'root-cause' node 612, an 'out-of-specification' node 614, and an 'out-of-population' node 616 in the Bayesian Network. A third causal node C in the causal graph is associated with a 'root-cause' node 622, an 'out-of-specification' node 624, and an 'out-of-population' node 626 in the Bayesian Network. All arrows (edges) in Figure 6 are weighted. The weights of the edges are part of the Bayesian network formalization. A weight is the conditional probability distribution for a node in the graph conditionally to its parent. These conditional probabilities are either computed by historical data or they are given as input from the domain experts.

As can be seen, a 'root-cause' node in the Bayesian Network corresponding to a node in the causal graph is connected with a weighted arrow to the 'out-of-specification' node that also corresponds to the particular node in the causal graph. For example, 'root-cause' node 602 for node A in the causal graph is connected with a weighted arrow to 'out-of-specification' node 604 for node A in the causal graph.

A weighted arrow is connected from an 'out-of-specification' node in the Bayesian Network (corresponding to a node in the causal graph) to another 'out-of-specification' node in the Bayesian Network (corresponding to another node in the causal graph) if the causal graph comprises an edge between the nodes in the causal graph. Thus it will be appreciated that an 'out-of-specification' node in the Bayesian Network can be connected to one or more other 'out-of-specification' nodes in the Bayesian Network. These weights are shown in Figure 6 whereby weight P_{(A,B)} quantifies the probability to which 'out-of-specification' behavior propagates from module A to module B, and weight P_{(B,C)} quantifies the probability to which 'out-of-specification' behavior propagates from module B to module C. The weights can be expressed more generally as a weight P_{(l,m)} where 1 identifies the module whose 'out-of-specification' behavior propagates to another module and m identifies the module affected by 'out-of-specification' behavior propagated from another module.

As can be seen, an 'out-of-specification' node in the Bayesian Network corresponding to a node in the causal graph is connected with a weighted arrow to the 'out-of-population' node that also corresponds to the particular node in the causal graph. These weights are shown in Figure 6 whereby the weighted arrow quantifies the probability P_{fp}, that an in-specification module behaves out-of-population, and also quantifies the probability P_{fn} that an out-of-specification module behaves out-of-population. The probability P_{fp} and the probability P_{fn} are the conditional probabilities for an 'out-of-population' node conditionally to its parent 'out-of-specification' node. Whilst other weights are present in the Bayesian network 600 we elaborate herein specifically on the probabilities P_{fp} and P_{fn} because they link the data observations (sensor data) to the rest of the network.

Edges and weights of nodes of the causal graph are used to calculate the specific conditional probability tables of the nodes in the Bayesian Network.

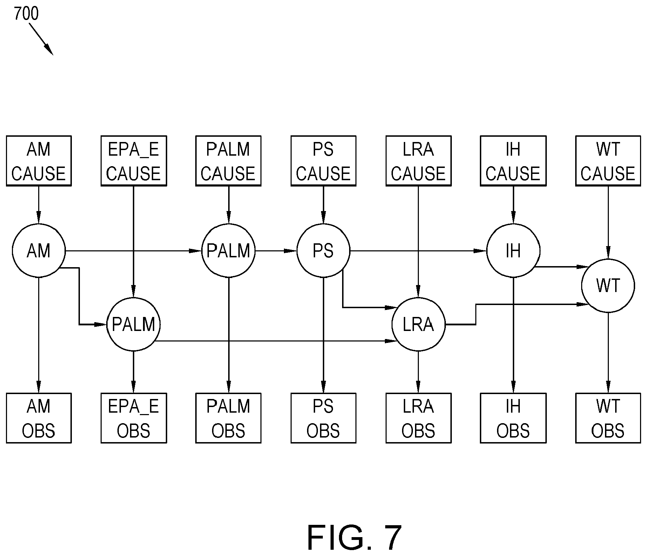

Figure 7 illustrates a Bayesian Network 700 that would be generated for the example causal graph shown in Figure 5. As shown in Figure 7, for each of the modules (air mounts AM, piezo active lens mount PALM, projection system PS, the Encoder Plater Assembly Exposure-side EPAE, the lens references axis LRA, the immersion hood IH, and the substrate support WT) the Bayesian Network 700 comprises a 'root-cause' node (rectangularly shaped "CAUSE" nodes), an 'out-of-specification' node (circularly shaped nopdes), and an 'out-of-population' node (rectangularly shaped "OBS" nodes). Some nodes in the causal graph (e.g. the node for the piezo active lens mount PALM) have a single arrow (edge) to another node in the causal graph, such 'out-of-specification' nodes in the Bayesian Network (e.g. the node for the piezo active lens mount PALM) have a weighted arrow to only one other 'out-of-specification' node in the Bayesian Network. In contrast, some nodes in the causal graph (e.g. the node for the projection system PS) have multiple arrows (edges) to other nodes in the causal graph, such 'out-of-specification' nodes in the Bayesian Network (e.g. the node for the projection system PS) have a weighted arrow to multiple other 'out-of-specification' nodes in the Bayesian Network.

Referring back to Figure 4, at step S406 the CPU 302 obtains a health metric for each of the modules of the system that defines the probability that the module is behaving out-of-population. The health metric for each module is related to signals associated with a plurality of sensors associated to the module (the causal graph identifying the grouping of sensors of the system into the identified modules).

The causal graph can be exploited to automatically create a custom metric calculation. The main goal of step S406 is to create a calculation that can identify modules that are behaving problematically, or in other words to create a health metric for each of the modules. Every module consists of a set of *n* signals, together creating a n-dimensional vector space. To incorporate time-depending behavior, it is also possible to create aggregations of time periods or certain frequencies and add this information to the module. Machine learning algorithms can then be implemented for each of the modules, that capture the out-of-population behavior, ranging from simple unsupervised population statistics to (semi-)supervised outlier detection methods (our preferred implementation). To create any (semi-)supervised algorithm, data associated with a population of healthy machines is utilized to which the faulty machines are compared.

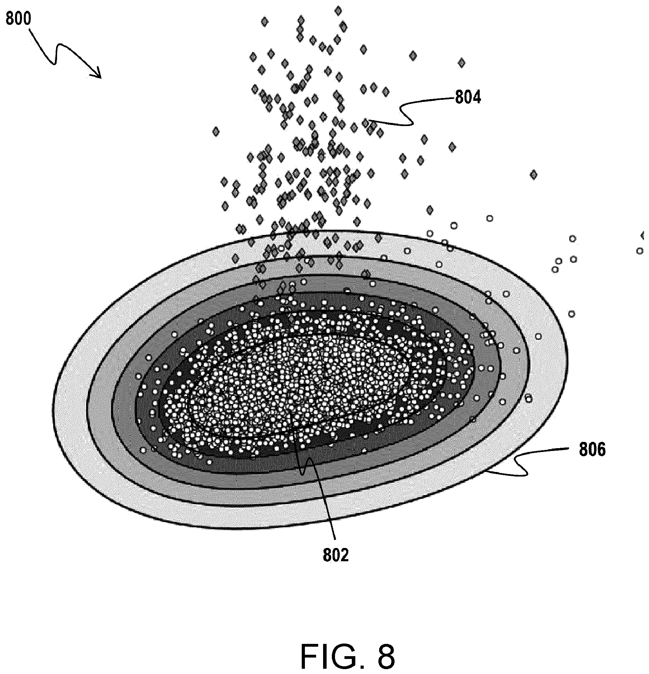

The health metric is a statistical score that aggregates all the measurements in one value. It is the output of a function that takes as input the multivariate measurements of a module of one system (e.g. machine) and outputs the discrepancy of the current input from a healthy behaviour in the form of a probability. The healthy behaviour could be defined via measurements of a population of healthy systems (e.g. machines) or via measurements of the current system (e.g. machine) before the problem occurs. To illustrate the former approach, Figure 8 shows a comparison 800 of sensor data 804 for a module of a specific machine to sensor data 802 for corresponding modules in healthy machines. As shown in Figure 8 some of the sensor data 804 for the module of the specific machine is outside of predefined bounds 806 that define typical behavior for a healthy module of that particular type. The health metric identifies out-of-population behavior for the module of the specific machine. The health metric may be determined using pure statistical methods like z-scores, outlier detection methods or other machine learning approaches.

When a system has an issue, as much information sensor data as possible for that machine can be collected in order to eliminate the likelihood that an issue passes unnoticed. As a result, the health metric becomes very sensitive to small deviations and it is possible measure that a module is out-of-population even if the module is not really out-of-specification. The probabilities Pfn and Pfp referred to above account for these sensitivities. The probabilities Pfn and Pfp can be considered as determining the errors of the health metric.

At step S406 for one or more of the modules, the CPU 302 may obtain the health metric for the module by generating the health metric based on sensor data received from sensors of that module. In particular, for each module several properties can be measured and the measured signals can deviate in different ways (obvious peaks, subtle outliers in multiple signals).

At step S406 for one or more of the modules, the CPU 302 may obtain the health metric for the module by receiving the health metric from the module. That is, a module may have the capability to determine the health metric based on sensor data captured by sensors of that module, and report the health metric to the CPU 302.

The CPU 302 uses the health metric as an input to the reasoning tool to identify a module of the system that is the most likely cause of the behaviour of the system. This is described below with reference to the example of the reasoning tool being a Bayesian network.

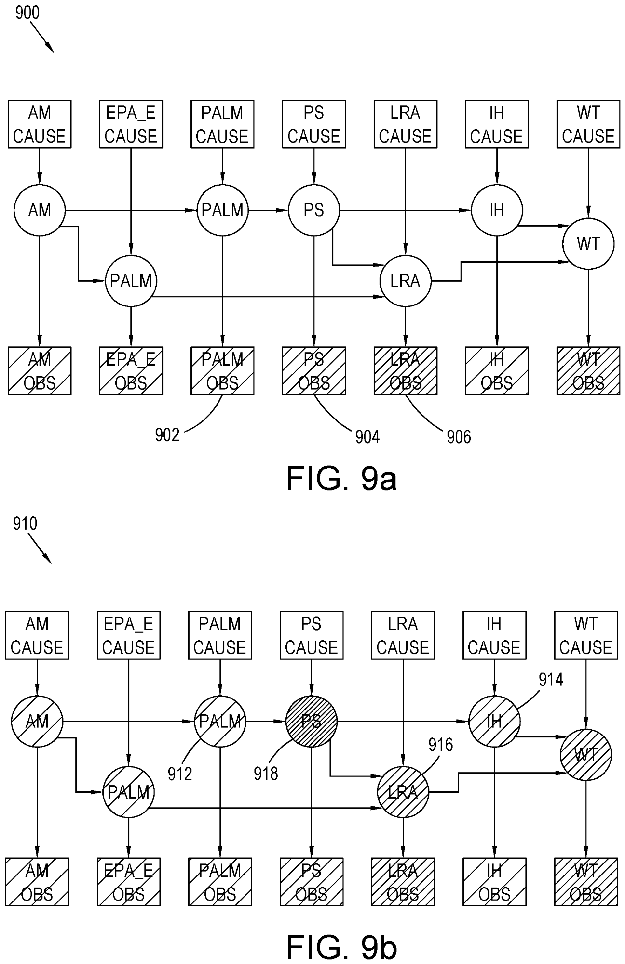

For each module the CPU 302 applies the health metric determined for the module at step S406 to the 'out-of-population' node for that module. Thus each 'out-of-population' node in the Bayesian network is assigned a score between 0 and 1, specifying the probability that the module behaves out-of-population. This is illustrated in Figure 9a by the Bayesian network 900. In Figure 9a, the more shading represents the higher probability of out-of-population behavior. Thus the out-of-population node 902 for the piezo active lens mount PALM indicates a low probability of out-of-population behavior, the out-of-population node 904 for the projection system PS indicates a medium probability of out-of-population behavior, and the out-of-population node 906 for the lens references axis LRA indicates a high probability of out-of-population behavior.

At step S408, the CPU 302 uses the Bayesian network 900 and the probabilities from the translation referred to above to calculate the probability that each module is out-of-specification, considering inter-module interactions and potential measurement errors. For each module the CPU 302 combines the probabilities P_{fp} and P_{fn} via a formula (based on Bayes' rule) to specify the probability that the module is out-of-specification if the module is measured to be out-of-population. It is, as such, a probability of propagation. While the health metric is a probability of the 'out-of-population' behaviour in itself. Together these two can be used by the CPU 302 to derive the probability that the module is out-of-specification. Expressed another way if the CPU 302 know the probability that the module is out-of-population (by the health metric), and the probability that if it is out-of-population, it is also out-of-specification (by combining the probabilities P_{fp} and P_{fn} for the module), the CPU 302 can calculate the probability that the module is out-of-specification. Since many modules may be interacting in a system, in order to compute the overall probability that a module is out-of-specification, in order to calculate the probability that the module is out-of-specification it is necessary to consider the influence of other modules. The Bayesian network facilitates the consideration of the relevant module interactions. To determine the probability that the module is out-of-specification, the CPU 302 uses (i) the probability that the module is out-of-population (the health metric for that module), (ii) the probabilities P_{fp} and P_{fn} for the module, and (iii) the influence of one or more other modules on that module i.e. using one or more weights P_{(l,m)}. Only when an expert manually inspects a module (expensive process), can it be known if a module is actually out-of-specification. Embodiments of the present invention can use the outcome of this inspection to update the Bayesian network. In order to help the expert to decide which module to inspect, out-of-specification behavior is first considered unobserved. When the inspection is completed, the outcome can be used as an extra observation.

The probabilities P_{fp} and P_{fn} can have different values for different modules in a system. A module that is sensitive and deviates easily, even in healthy machines, will have higher Pfp than a module with standard behavior.

At step S408 each 'out-of-specification' node in the Bayesian network is assigned a score between 0 and 1, specifying the probability that the module behaves out-of-specification. This is illustrated in Figure 9b by the Bayesian network 910. In Figure 9b, the more shading represents the higher probability of out-of-specification behavior. Thus the out-of-specification 912 for the piezo active lens mount PALM indicates a low probability of out-of-specification behavior, the out-of-specification 914 for the immersion hood indicates a medium probability of out-of-specification behavior, the out-of-specification node 916 for the lens references axis LRA indicates a high probability of out-of-specification behavior, and the out-of-specification node 918 for the projection system PS 918 indicates a very high probability of out-of-specification behavior.

At step S410, the CPU 302 uses the out-of-specification probabilities to determine a probability (i.e. a confidence value), for each module, that the module is the root cause of the system behavior. At step S410, the CPU 302 uses the the Bayesian network to determine the probabilities that the modules are the root cause of the system behavior. In particular, step S410 is performed using known techniques with a Bayesian update similar to the computation of the out-of-specification probabilities referred to above. The CPU 302 generates a list of potential root causes (a list of modules in the system), with confidence value for each root cause. The confidence value for each module in the list defines a confidence that the respective module is the cause of the system behaviour

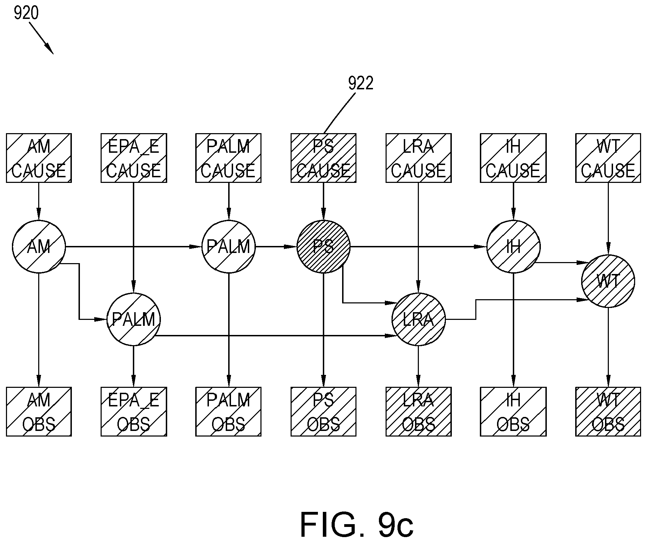

At step S410, the CPU 302 identifies a module in the system that is the most likely cause of the behaviour of the system which has the highest confidence value. In the example shown in Figure 9c, it is the projection system PS that has been identified as the most likely cause of the behaviour of the system. The CPU 302 may output, via the output device 308, an indication of the module of the system that is the most likely root cause of abnormal behaviour.

Whilst we have referred above to a Bayesian network in relation to the reasoning tool, this is merely an example and alternatives may be used in embodiments of the present invention. For example, other approaches like rule-based reasoning (where the rules are distilled from the causal graph) may be used, or more data-driven approaches (like Graph Neural Networks or Structural Equation Modelling) may be used, where the structure of the causal graph is exploited to identify neighboring modules that can explain behavior.

Any reasoning tool used would have the goal to interpret both the signals from an individual system/machine and the causal graph, and be able to distinguish signal (actual out-of-spec modules) from noise (statistical errors in the measurement) by exploiting the knowledge of related modules in its surroundings. A translation to a rule-based approach would allow for use of existing rule-based reasoning tools, likely giving stronger visualization toolings, but at the cost of a non-native implementation of probabilities and uncertainties.

Any translation algorithm that introduce the knowledge of the difference between Causal, Out-of-specification and out-of-population may be used, since this information is hidden in the causal graph and needs to be introduced by the algorithm.

While existing diagnostic techniques uses data to support experts in finding anomalistic behavior, it requires significant domain expertise to use and to work with. Embodiments of the present invention includes that needed domain knowledge directly into the application, enabling customer support with less expert knowledge to diagnose difficult problems. This leads to faster diagnostics through less escalations to more expert customer support.

The formal semantics of the domain knowledge creates the possibility to collaborate between human experts and data-driven techniques. Feedback in the pipelines can be captured and reused to improve the central knowledge base (the causal graph). For example, this can be feedback on the estimated root-cause created by the pipeline, which can be used to reweigh the scores and probabilities of failure and influence.

Embodiments of the present disclosure provide a number of advantages:
- An explicit representation of knowledge (e.g. the causal graph) allows for collaboration between experts on this knowledge base. They can discuss influences and since the semantics of this knowledge is visual and clear, modifications are easy to make. On top of this, the fact that the causal graph has a formal and exact semantics enables human-machine collaboration.
- This explicit representation also makes the framework less error-prone because decisions and knowledge are central and visible and not hidden implicitly in code or models.
- It is trivial to modify knowledge without changing any code in the pipeline and enables easy reuse of components to other, similar diagnostic tasks.
- The abstraction of the causal graph creates robustness since it does not reason over specific implementations (such as sensors and signals) but over high level concepts such as modules and causes.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A computer implemented method for diagnosing a system comprising a plurality of modules, the method comprising:
receiving a causal graph, the causal graph defining (i) a plurality of nodes each representing a module of the system , wherein each module is **characterized by** one or more signals; and (ii) edges connected between the plurality of nodes, the edges representing propagation of performance between modules;
generating a reasoning tool by augmenting the causal graph with diagnostics knowledge based on historically determined relations between performance, statistical and causal characteristics of at least one module out of the plurality of modules;
obtaining a health metric of the at least one module, wherein the health metric is associated with the one or more signals associated with the at least one module; and
using the health metric as an input to the reasoning tool to identify a module that is the most likely cause of the behaviour of the system.

2. The computer implemented method of claim 1, wherein each node of the causal graph is associated with a first score quantifying a probability that the module of the system, represented by the node in the causal graph, is behaving out-of-specification and out-of-population; and a second score quantifying a probability that the module of the system, represented by the node in the causal graph, is out-of-population without behaving out-of-specification.

3. The computer implemented method of claim 1 or 2, wherein each of the edges of the causal graph is assigned a weight quantifying the probability to which abnormal behaviour propagates from one module to another.

4. The computer implemented method of any preceding claim, wherein the health metric defines a probability that the module behaves out-of-population.

5. The computer implemented method of claim 4, wherein obtaining the health metric for each module comprises comparing the sensor signals mapped to the respective module to sensor data of at least one corresponding module of a system that is not exhibiting abnormal behaviour.

6. The computer implemented method of any preceding claim, further comprising generating a list of modules of the system that are potentially a root cause of the behavior of the system, and a confidence value for each module in the list defining a confidence that the respective module is the root cause of the abnormal behaviour, wherein the identified module has the highest confidence value.

7. The computer implemented method of any preceding claim, wherein the reasoning tool comprises a network comprising:
first type nodes each representing that an associated module of the system is behaving out-of-specification, and first type edges indicating a probability of out-of-specification behaviour propagating between two first type nodes; and
second type nodes each connected to a corresponding first type node by a second edge indicating at least one probability relating to the module, associated with the corresponding first type node, behaving out-of-population.

8. The computer implemented method of claim 7, wherein the at least one probability comprises:
a probability that the module associated with the corresponding first type node is behaving out-of-specification and out-of-population; and
a probability that the module associated with the corresponding first type node is behaving out-of-population without behaving out-of-specification.

9. The computer implemented method of claim 7 or 8, wherein the method comprises assigning each health metric to a corresponding second type node of the second type nodes.

10. The computer implemented method of any of claims 7 to 9, wherein the network is a Bayesian network.

11. The computer implemented method of any preceding claim, wherein the method further comprises outputting, to a user, an indication of the module of the system that is the most likely root cause of the behavior of the system.

12. The computer implemented method of any preceding claim, wherein the system is a lithographic machine.

13. The computer implemented method of any preceding claim, wherein the system is a component of a lithographic machine.

14. A computer-readable storage medium for diagnosing a system comprising a plurality of modules, the computer-readable storage medium comprising instructions which, when executed by a processor of a computing device cause the computing device to perform the method of any preceding claim.

15. A computing device for diagnosing a system comprising a plurality of modules, the computing device comprising a processor configured to:
receive a causal graph, the causal graph defining (i) a plurality of nodes each representing a module of the system, wherein each module is **characterized by** one or more signals; and (ii) edges connected between the plurality of nodes, the edges representing propagation of performance between modules;
generate a reasoning tool by augmenting the causal graph with diagnostics knowledge based on historically determined relations between performance, statistical and causal characteristics of at least one module out of the plurality of modules;
obtain a health metric of the at least one module, wherein the health metric is associated with the one or more signals associated with the at least one module; and
use the health metric as an input to the reasoning tool to identify a module that is the most likely cause of the behaviour of the system.
